# EUROPEAN PATENT APPLICATION

(11) **EP 3 346 516 A1**
(43) Date of publication of application: **11.07.2018**
(21) Application number: 17196605.4
(22) Date of filing: 16.10.2017
(51) Int. Cl.: H01L 51/52

(54) **SUBSTRATE, OLED ENCAPSULATION STRUCTURE, AND MANUFACTURING METHOD OF OLED ENCAPSULATION STRUCTURE**

(30) Priority: 10.01.2017 CN 201710016020
(71) Applicant: Guangdong Oppo Mobile Telecommunications Corp., Ltd., Dongguan, Guangdong 523860 (CN)
(72) Inventor: JIN, Yong, Dongguan, Guangdong 523860 (CN)
(74) Representative: advotec.

(57) **Abstract**

A substrate, an OLED encapsulation structure and a method for manufacturing the OLED encapsulation structure are provided. The substrate includes a display area, an encapsulation area surrounding the display area and a metal loop wire. The OLED encapsulation structure includes: a substrate defining a display area and an encapsulation area surrounding the display area; an OLED device layer provided in the display area; a metal loop wire provided in the encapsulation area and having no electrical function; an inorganic encapsulation material layer provided in the encapsulation area and covering the metal loop wire; and a cover plate connected with the substrate through the inorganic encapsulation material layer in a sealed manner. By separately providing the metal loop wire, it is possible to accelerate temperature rise of the inorganic encapsulation material greatly, thereby rapidly melting and sintering it together, and protect ESD effectively, thereby extending service life of the OLED.

## Description

### FIELD

The present disclosure relates to a field of display technology, and particularly, to a substrate, an organic light-emitting diode (OLED) encapsulation structure and a method for manufacturing the same.

### BACKGROUND

An OLED relates to a display technology using an organic polymer material as a semiconductor material in a light-emitting diode. The OLED is self-luminous and flexible, and has high brightness, a wide viewing angle, high contrast, low power consumption and other characteristics. The OLED is widely applied in mobile phones, digital cameras, DVD players, personal digital assistants (PDA), notebook computers, car audios and televisions. The OLED is internally provided with an organic light-emitting material that is easy to be oxidized, and hence needs to be sealed. An existing solution adopts a sintering method to seal an edge. Currently, an edge-sealing material with ideal performance is silica, but it is difficult to sinter silica together due to its high melting point.

Therefore, the current OLED encapsulating technology remains to be improved.

### SUMMARY

The present disclosure aims to solve one of technical problems in the related art at least to a certain extent.

In an aspect of the present disclosure, an OLED encapsulation structure is provided in the present disclosure. According to embodiments of the present disclosure, the OLED encapsulation structure includes: a substrate defining a display area and an encapsulation area surrounding the display area; an OLED device layer provided in the display area; a metal loop wire provided in the encapsulation area and having no electrical function; an inorganic encapsulation material layer provided in the encapsulation area and covering the metal loop wire; and a cover plate connected with the substrate through the inorganic encapsulation material layer in a sealed manner. By separately providing the metal loop wire, the inventor finds it possible to accelerate the temperature rise of the inorganic encapsulation material greatly, thereby rapidly melting and sinter it together, and protect the ESD effectively on the other hand, thereby extending the service life of the OLED.

According to embodiments of the present disclosure, the OLED encapsulation structure further includes a frame adhesive layer provided in the encapsulation area and located at a side of the metal loop wire adjacent to the display area.

According to embodiments of the present disclosure, the OLED encapsulation structure further includes a desiccant provided to a lower surface of the cover plate.

According to embodiments of the present disclosure, the OLED device layer includes a power cord electrically connected with the OLED device layer and a power source, and a gap exists between the power cord and the metal loop wire.

According to embodiments of the present disclosure, the substrate is a glass substrate, a polymer substrate, or a metal substrate.

According to embodiments of the present disclosure, the metal loop wire is formed of at least one of gold, silver and copper.

According to embodiments of the present disclosure, the inorganic encapsulation material layer is formed of at least one of silicon dioxide, silicon nitride and aluminum oxide.

According to embodiments of the present disclosure, the cover plate is a glass cover plate.

In another aspect of the present disclosure, a substrate is provided in the present disclosure. The substrate includes a display area, an encapsulation area surrounding the display area, and a metal loop wire provided in the encapsulation area and having no electrical function.

In still another aspect of the present disclosure, a method for manufacturing the above OLED encapsulation structure is provided. According to embodiments of the present disclosure, the method includes: providing a substrate that defines a display area and an encapsulation area surrounding the display area; forming an OLED device layer in the display area; forming a metal loop wire in the encapsulation area, in which the metal loop wire has no electrical function; forming an inorganic encapsulation material layer in the encapsulation area, in which the inorganic encapsulation material layer covers the metal loop wire; and connecting a cover plate to the substrate oppositely. The inventor finds that the previously mentioned OLED encapsulation structure can be obtained rapidly and effectively in this method which is easy and convenient to operate; by the separate provision of the metal loop wire in the encapsulation area, when the cover plate is oppositely connected to the substrate, the temperature rise of the inorganic encapsulation material can be accelerated, and hence the inorganic encapsulation material is rapidly melted and sintered together; and moreover, the ESD can be protected effectively and the service life of the OLED can be prolonged.

According to embodiments of the present disclosure, before connecting the cover plate to the substrate oppositely, the method further includes forming a frame adhesive layer in the encapsulation area, in which the frame adhesive layer is located at a side of the metal loop wire adjacent to the display area.

According to embodiments of the present disclosure, the method for manufacturing the OLED encapsulation structure further includes curing the frame adhesive.

According to embodiments of the present disclosure, before connecting the cover plate to the substrate oppositely, the method further includes providing a desiccant to a lower surface of the cover plate.

### BRIEF DESCRIPTION OF THE DRAWINGS

Fig. 1 illustrates a schematic view of an OLED encapsulation structure according to an embodiment of the present disclosure.
Fig. 2 illustrates a schematic view of a TFT according to an embodiment of the present disclosure.
Fig. 3 illustrates a schematic view of an OLED device layer according to an embodiment of the present disclosure.
Fig. 4 illustrates a schematic view of an OLED encapsulation structure according to another embodiment of the present disclosure.
Fig. 5 illustrates a schematic view of an OLED encapsulation structure according to still another embodiment of the present disclosure.

### DETAILED DESCRIPTION

Embodiments of the present disclosure will be described in detail. The embodiments described below are explanatory and are only used to interpret the present disclosure rather than constructed to limit the present disclosure. If not indicated in the embodiments, specific techniques or conditions are either in accordance with the techniques or conditions described in the literature of the art or in accordance with product specifications. If manufactures of reagents or instruments used here are not indicated, the reagents and instruments are both conventional products that are commercially available.

The present disclosure is completed based on the following findings of the inventor.

At present, OLED encapsulation materials generally include organic materials or inorganic materials. However, organic materials tend to form defects such as small pores, such that the encapsulation structure cannot effectively isolate an OLED device from moisture, oxygen and the like in the air, thereby affecting service life of the OLED device. Inorganic materials usually have better moisture isolation performance, but silica generally utilized as the encapsulation material nowadays has a high melting point and is hard to sinter together. Considering this problem, the inventor finds it possible to accelerate temperature rise to melt the encapsulation material rapidly to sinter the encapsulation material together, by adding a metal layer to a side of the encapsulation material. The inventor finds that a metal wiring (or called power cord) in a structure of the OLED device can be provided in a position corresponding to the encapsulation material, to bring about an effect of accelerating the melting of the encapsulation material when the metal wiring plays an electrical function. With such a structure, the metal wiring may however be exposed to the outside, easily corroded, and then normal display of a display screen is affected. Through intensive study, the inventor finds that a circle of metal material at a certain distance from a metal lead wire separately provided at the position corresponding to the encapsulation material can not only play the role of accelerating the temperature rise effectively, but also protect electrostatic discharge (ESD), prevent the metal lead wire from being corroded and prolong the service life of the OLED.

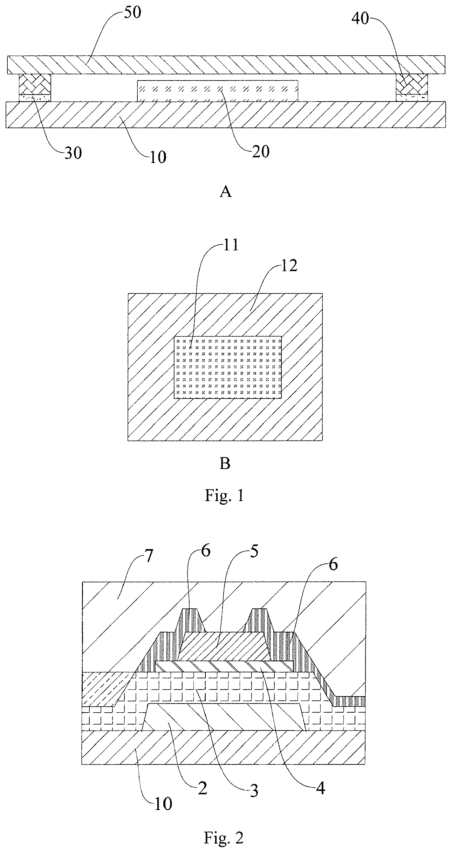

In an aspect of the present disclosure, an OLED encapsulation structure is provided. According to embodiments of the present disclosure, as illustrated in Fig. 1, the OLED encapsulation structure includes: a substrate 10 defining a display area 11 and an encapsulation area 12 surrounding the display area 11; an OLED device layer 20 provided in the display area 11; a metal loop wire 30 provided in the encapsulation area 12 and having no electrical function; an inorganic encapsulation material layer 40 provided in the encapsulation area 12 and covering the metal loop wire 30; a cover plate 50 connected with the substrate 10 through the inorganic encapsulation material layer 40 in a sealed manner. The inventor finds that by separately providing the metal loop wire, it is possible to accelerate temperature rise of the inorganic encapsulation material greatly, thereby rapidly melting and sintering it together, and protect ESD effectively, thereby extending service life of the OLED.

According to embodiments of the present disclosure, the specific material of the substrate that can be used is not particularly limited, and can be selected flexibly by those skilled in the art according to actual needs. In some embodiments of the present disclosure, the substrate that can be used is a glass substrate or a polymer substrate. In an optional case, the glass substrate can be adopted. Thus, the glass substrate can exhibit good bendability, good visible light permeability, favorable barrier properties to water vapor and oxygen, excellent chemical and thermal stability, high surface finish, and insulation property, and hence is an ideal OLED substrate. According to embodiments of the present disclosure, the substrate 10 can be provided with a device structure for the OLED in advance. For example, the substrate 10 is provided with a TFT (thin film transistor) structure in some embodiments of the present disclosure. Specifically, as illustrated in Fig 2, the TFT structure can include: a gate metal layer 2 on the substrate 10, a gate insulating layer 3 on the gate metal layer 2 and the substrate 10, a semiconductor layer 4 on the gate insulating layer 3, an etch blocking layer 5 on the semiconductor layer 4 and the gate insulating layer 3, a source-drain metal layer 6 on the etch blocking layer 5, the semiconductor layer 4 and the gate insulating layer 3, and a passivation layer 7 on the source-drain metal layer 6 and the etch blocking layer 5. It could be understood by those skilled in the art that the TFT structure is not limited to the structure illustrated in Fig. 2 and instead can be selected based on practical needs; for example, a top-gate type TFT or the like can be employed and fall into the protection scope of the present disclosure, which will not be elaborated herein.

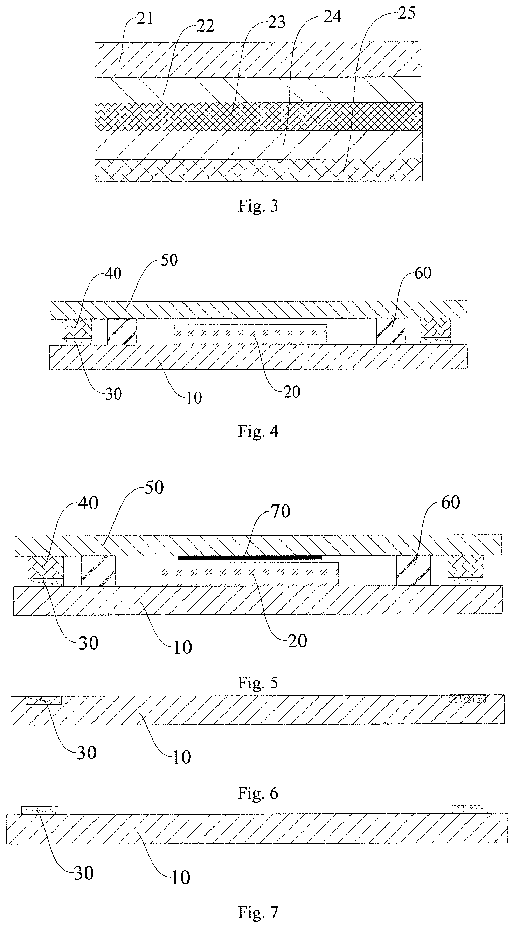

According to embodiments of the present disclosure, the specific structure of the OLED device layer is not particularly limited either, and can be any known OLED device structure in the art, including but not limited to a single-layer device structure, a two-layer device structure, a three-layer device structure, or a multi-layer device structure. In some embodiments of the present disclosure, the three-layer device structure is taken as an example to elaborate the specific structure of the OLED device layer. Specifically, as illustrated in Fig. 3, the OLED device layer includes: a metal cathode 21, an electron transport layer 22, a light-emitting layer 23, an electron hole transport layer 24, and an anode 25, such that it can have an excellent display effect. Certainly, it could be understood by those skilled in the art that the structure of the OLED device layer of the present disclosure is not limited to the structure illustrated in Fig. 3, and other similar structure variants or alternatives fall into the protection scope of the present disclosure.

According to embodiments of the present disclosure, apart from the metal cathode 21, the electron transport layer 22, the light-emitting layer 23, the electron hole transport layer 24, and the anode 25, the OLED device layer further includes a power cord used to connect the OLED device with an external power source. Normally, the power cord is provided at the periphery of the OLED device layer, that is, in a direction close to the metal loop wire. In the OLED encapsulation structure of the present disclosure, there is a gap between the power cord and the metal loop wire. Thus, the power cord is not exposed and corroded, the using performance of the OLED is significantly improved, and the service life is prolonged.

According to embodiments of the present disclosure, the specific metal type of the metal loop wire is not particularly limited, as long as the temperature rise of the inorganic encapsulation material can be effectively accelerated. In some embodiments of the present disclosure, the metal loop wire can be formed of at least one of gold, silver and copper. Thus, the metal loop wire has good thermal conductivity, and the inorganic encapsulation material can be quickly melted and sintered together.

According to embodiments of the present disclosure, the specific type of the inorganic encapsulation material which can be used is not particularly limited, as long as encapsulation requirements can be satisfied, and thus those skilled in the art can flexibly determine the type. In some embodiments of the present disclosure, the inorganic encapsulation material layer can be formed of at least one of silicon dioxide, silicon nitride and aluminum oxide. Therefore, the inorganic encapsulation material has good water vapor and oxygen isolation performance and can effectively ensure that the organic light-emitting material is not oxidized, thereby prolonging the service life of the OLED.

According to embodiments of the present disclosure, the specific material of the cover plate which can be used is not particularly limited, and instead can be flexibly selected by those skilled in the art based on practical needs. In some embodiments of the present disclosure, the cover plate is a glass cover plate, and thus exhibits good bendability, good visible light permeability, favorable barrier properties to water vapor and oxygen, excellent chemical and thermal stability, high surface finish, and insulation property.

According to embodiments of the present disclosure, as illustrated in Fig. 4, the OLED encapsulation structure further includes a frame adhesive layer 60 provided in the encapsulation area 12 and located at a side of the metal loop wire 30 adjacent to the display area 11. Thus, it is possible to greatly enhance bonding strength between the cover plate and the substrate, so as to significantly improve an encapsulation effect, and upgrade the using performance of the OLED.

According to embodiments of the present disclosure, the specific type of the frame adhesive which can be used is not particularly limited, and instead can be flexibly selected by those skilled in the art based on practical needs. In some embodiments of the present disclosure, the frame adhesive used here includes but is not limited to a ultraviolet curing adhesive or thermosetting adhesive, for example, a thermosetting adhesive made of mixture of epoxy resin, a catalyst and a catalyst solvent. Thus, the frame adhesive is convenient to process, and has a wide range of raw materials, low cost and good adhesion.

According to embodiments of the present disclosure, as illustrated in Fig. 5, the OLED encapsulation structure further includes a desiccant 70 provided to a lower surface of the cover plate 50. As a result, it is possible to effectively absorb a small amount of water vapor entering the inside of the OLED, and ensure that the organic light-emitting material is not oxidized, thereby improving the using performance of the OLED and prolonging the service life thereof.

According to embodiments of the present disclosure, the specific type of the desiccant which can be used is not particularly limited, and instead can be flexibly selected by those skilled in the art based on practical needs. In some embodiments of the present disclosure, the desiccant used here includes but is not limited to chlorine-containing polymers, silica gel, activated alumina and the like. Thus, the desiccant has good hygroscopy, and can effectively reduce the oxidation of the organic light-emitting material in the OLED and prolong the service life of the OLED device.

In another aspect of the present disclosure, a substrate 10 is provided in the present disclosure. The substrate 10 includes a display area 11, an encapsulation area 12 surrounding the display area 11, and a metal loop wire 30 provided in the encapsulation area 12 and having no electrical function. The display area 11 and the encapsulation area 12 are as illustrated in Fig. 1. According to embodiments of the present disclosure, as illustrated in Fig. 6, the metal loop wire 30 is embedded in the encapsulation area 12 and an upper surface of the metal loop wire 30 is flush with an upper surface of the encapsulation area 12.

According to embodiments of the present disclosure, as illustrated in Fig. 7, the metal loop wire 30 is provided on an upper surface of the encapsulation area 12.

In still another aspect of the present disclosure, a method for manufacturing the above OLED encapsulation structure is provided. According to embodiments of the present disclosure, the method includes: providing a substrate that defines a display area and an encapsulation area surrounding the display area; forming an OLED device layer in the display area; forming a metal loop wire in the encapsulation area, in which the metal loop wire has no electrical function; forming an inorganic encapsulation material layer in the encapsulation area, in which the inorganic encapsulation material layer covers the metal loop wire; and connecting a cover plate to the substrate. The inventor finds that the previously mentioned OLED encapsulation structure can be obtained rapidly and effectively in this method which is easy and convenient to operate; by the separate provision of the metal loop wire in the encapsulation area, when the cover plate is connected to the substrate, the temperature rise of the inorganic encapsulation material can be accelerated, and hence the inorganic encapsulation material is rapidly melted and sintered together; and moreover, the ESD can be protected effectively and the service life of the OLED can be prolonged.

According to embodiments of the present disclosure, the substrate, the OLED device layer, the metal loop wire, the inorganic encapsulation material layer and the cover plate herein are the same as described above, and will not be elaborated herein. Methods for forming the substrate, the OLED device layer, the metal loop wire and the inorganic encapsulation material layer are not particularly limited, and can adopt any known methods in the art, including but not limited to such as sputtering, vapor deposition, chemical deposition and the like. Thus, the operation is convenient, and the method is mature and easy to realize.

According to embodiments of the present disclosure, before connecting the cover plate to the substrate, the method can further include forming a frame adhesive layer in the encapsulation area, in which the frame adhesive layer is located at a side of the metal loop wire adjacent to the display area. Specifically, the method for forming the frame adhesive layer includes but is not limited to spraying, coating and the like. Thus, the bonding strength between the cover plate and the substrate can be improved further, and the using performance of the OLED is upgraded. The frame adhesive herein is the same as described above, and thus will not be elaborated.

According to embodiments of the present disclosure, the method for manufacturing the OLED encapsulation structure further includes curing the frame adhesive. According to embodiments of the present disclosure, the step of curing the frame adhesive can be carried out by irradiation with ultraviolet light or heating, which can be selected based on the type of the frame adhesive.

According to embodiments of the present disclosure, before connecting the cover plate to the substrate, the method can further include providing a desiccant to a lower surface of the cover plate. The desiccant herein is the same as described above, and thus will not be elaborated. According to embodiments of the present disclosure, the provision of the desiccant to the lower surface of the cover plate can be carried out by coating, spraying or the like, which can be selected by those skilled in the art based on the type of the desiccant and actual working environment.

Reference throughout this specification to "an embodiment," "some embodiments," "an example," "a specific example" or "some examples" means that a particular feature, structure, material, or characteristic described in connection with the embodiment or example is included in at least one embodiment or example of the present disclosure. Thus, the appearances of the above phrases throughout this specification are not necessarily referring to the same embodiment or example of the present disclosure. Furthermore, the particular features, structures, materials, or characteristics may be combined in any suitable manner in one or more embodiments or examples.

Although explanatory embodiments have been illustrated and described, it would be appreciated by those skilled in the art that the above embodiments are explanatory and cannot be construed to limit the present disclosure, and changes, modifications, alternatives and variants can be made in the embodiments without departing from the scope of the present disclosure.

## Claims

1. An OLED encapsulation structure, comprising:
a substrate (10) defining a display area (11) and an encapsulation area (12) surrounding the display area (11);
an OLED device layer provided in the display area (11);
a metal loop wire (30) provided in the encapsulation area (12) and having no electrical function;
an inorganic encapsulation material layer (40) provided in the encapsulation area (12) and covering the metal loop wire (30); and
a cover plate (50) connected with the substrate (10) through the inorganic encapsulation material layer (40) in a sealed manner.

2. The OLED encapsulation structure according to claim 1, further comprising a frame adhesive layer (60) provided in the encapsulation area (12) and located at a side of the metal loop wire (30) adjacent to the display area (11).

3. The OLED encapsulation structure according to claim 1 or 2, further comprising a desiccant (70) provided to a lower surface of the cover plate (50).

4. The OLED encapsulation structure according to any one of claims 1 to 3, wherein the OLED device layer further comprises a power cord electrically connected with the OLED device layer and a power source, and a gap exists between the power cord and the metal loop wire (30).

5. The OLED encapsulation structure according to any one of claims 1 to 4, wherein the substrate (10) is a glass substrate or a polymer substrate.

6. The OLED encapsulation structure according to any one of claims 1 to 5, wherein the metal loop wire (30) is formed of at least one of gold, silver and copper.

7. The OLED encapsulation structure according to any one of claims 1 to 6, wherein the inorganic encapsulation material layer (40) is formed of at least one of silicon dioxide, silicon nitride and aluminum oxide.

8. The OLED encapsulation structure according to one of claims 1 to 7, wherein the cover plate (50) is a glass cover plate.

9. A substrate (10), comprising:
a display area (11);
an encapsulation area (12) surrounding the display area (11); and
a metal loop wire (30) provided in the encapsulation area (12) and having no electrical function.

10. The substrate (10) according to claim 9, wherein the metal loop wire (30) is embedded in the encapsulation area (12) and an upper surface of the metal loop wire (30) is flush with an upper surface of the encapsulation area (12).

11. The substrate (10) according to claim 9, wherein the metal loop wire (30) is provided on an upper surface of the encapsulation area (12).

12. A method for manufacturing an OLED encapsulation structure according to any one of claims 1 to 8, comprising:
providing a substrate (10) that defines a display area (11) and an encapsulation area (12) surrounding the display area (11);
forming an OLED device layer in the display area (11);
forming a metal loop wire (30) in the encapsulation area (12), in which the metal loop wire (30) has no electrical function;
forming an inorganic encapsulation material layer (40) in the encapsulation area (12), in which the inorganic encapsulation material layer (40) covers the metal loop wire (30); and
connecting a cover plate (50) to the substrate (10) oppositely.

13. The method according to claim 12, further comprising forming a frame adhesive layer (60) in the encapsulation area (12), before connecting the cover plate (50) to the substrate (10) oppositely, in which the frame adhesive layer (60) is located at a side of the metal loop wire (30) adjacent to the display area (11).

14. The method according to claim 13, further comprising curing the frame adhesive layer (60).

15. The method according to any one of claims 12 to 14, further comprising providing a desiccant (70) to a lower surface of the cover plate (50), before connecting the cover plate (50) to the substrate (10) oppositely.
